(19) Europäisches Patentamt / European Patent Office / Office européen des brevets

(11) **EP 3 963 290 B1**

(12) **EUROPEAN PATENT SPECIFICATION**

(45) Date of publication and mention
of the grant of the patent:
**25.06.2025 Bulletin 2025/26**

(21) Application number: **19926761.8**

(22) Date of filing: **28.04.2019**

(51) International Patent Classification (IPC):
*G01D 3/028* (2006.01)     *F02D 9/00* (2006.01)
*F02D 11/10* (2006.01)     *F02D 35/00* (2006.01)
*G01B 7/00* (2006.01)      *G01D 5/22* (2006.01)

(52) Cooperative Patent Classification (CPC):
**G01D 3/0365; B64C 1/1407; B64C 25/001;
B64D 45/0005; H03K 17/9517**

(86) International application number:
**PCT/US2019/029546**

(87) International publication number:
**WO 2020/222726 (05.11.2020 Gazette 2020/45)**

(54) **TEMPERATURE COMPENSATION METHOD FOR HALL EFFECT PROXIMITY SENSORS**

VERFAHREN ZUR TEMPERATURKOMPENSATION FÜR
HALL-EFFEKT-NÄHERUNGSSENSOREN

PROCÉDÉ DE COMPENSATION DE TEMPÉRATURE DESTINÉ À DES CAPTEURS DE PROXIMITÉ
À EFFET HALL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**09.03.2022 Bulletin 2022/10**

(73) Proprietor: **Harco, LLC
Branford CT 06405 (US)**

(72) Inventor: **GITERMAN, Igor
Woodbridge, CT 06525 (US)**

(74) Representative: **FRKelly
Waterways House
Grand Canal Quay
Dublin D02 PD39 (IE)**

(56) References cited:
DE-C1- 10 046 147     US-A1- 2004 102 914
US-A1- 2009 128 141   US-A1- 2010 141 153
US-A1- 2011 285 404   US-A1- 2014 117 979

• "Aircraft Electrical and Electronic Systems -
Principles, Operation and Maintenance", 21
August 2009, Great Britain, ISBN:
978-0-7506-8695-2, article DAVID WYATT ET AL:
"Aircraft Electrical and Electronic Systems -
Principles, Operation and Maintenance",
XP055610484
• "Hall-Effect Sensors : Theory and Applications",
1 January 2006, ISBN: 978-0-75-067934-3, article
EDWARD   RAMSDEN: "Hall-Effect Sensors :
Theory and Applications", pages: 151 - 176,
XP055039221
• "Light sensors", MACHINE DESIGN,, vol. 54, no.
11, 1 May 1982 (1982-05-01), pages 195 - 212,
XP001348421

EP 3 963 290 B1

**Description**

## FIELD OF THE INVENTION

The present invention relates generally to sensors for aerospace applications that operate based on the Hall Effect principle, and more particularly to an article and method for making these sensors fully-functional over a wide operating temperature range.

## BACKGROUND OF THE INVENTION

In today's modern aircraft, there are many locations that require a positive position indication to ensure that safety conditions are met. One such example is the cabin door of an aircraft, wherein if the cabin door is not fully secured the safety of the passengers and crew is at risk. In fact, if the cabin door is not fully secured the survivability of the entire aircraft may be threatened. For example, an incorrect indication that the cabin door is secured may cause the aircraft to takeoff when the passenger cabin is not properly sealed. This can prevent the cabin Environmental Control System (ECS) from operating properly and thus, pressurization of the cabin may not occur as discussed below.

Another such example is the aircraft's Weight-On-Wheels (WOW) system. The WOW system typically utilizes safety critical proximity sensors (WOW sensors) that are configured to detect when a landing gear strut is fully-compressed. These WOW sensors may also be tied to a variety of additional complex systems such as brakes, aircraft pressurization, and spoilers. In fact, without the WOW sensors, the pilot may not know when the aircraft is in the air or on the ground. Failure of this type of switch could translate to the pilot being unable to retract the gear on takeoff because the system 'thinks' that the aircraft is still on the ground. Additionally, in turbine aircraft, the WOW sensors keep the pilot from pressuring the cabin while on the ground, and thus failure of this sensor may keep the pilot from pressuring the cabin in the air.

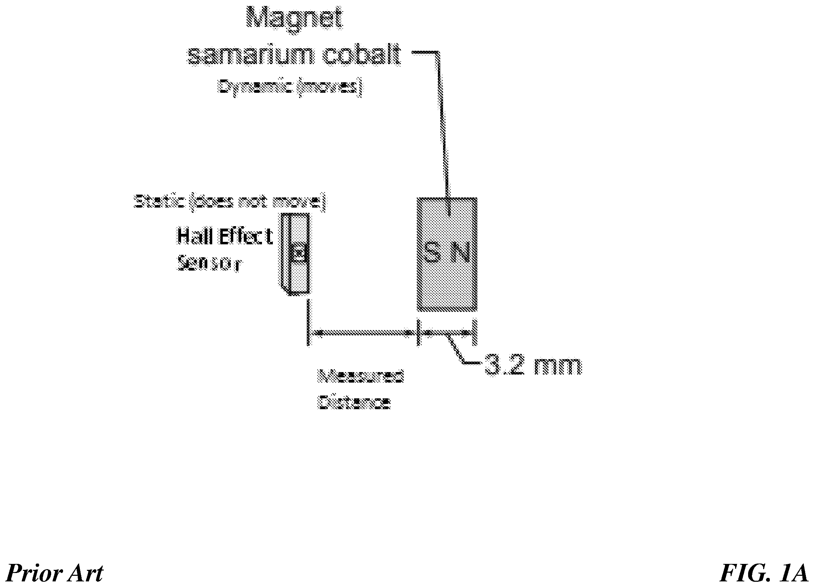

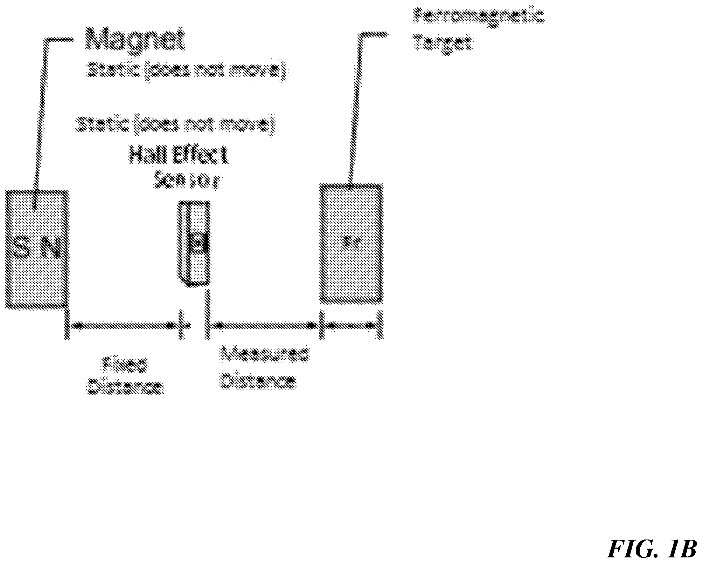

In some cases, aircraft systems use a hall effect sensor/switch that detects the position (proximity) of a metal target (object), wherein the metal target is constructed from a ferromagnetic material. FIG. 1 illustrates a general hall-effect sensor configuration. Unfortunately, however, hall effect sensors as proximity indicators typically only operate well over a narrow temperature range such as -20°C to +50°C. This is undesirable because the typical operating temperature range of aviation electronics can be between -55°C to +125°C. One way to address this narrow operating range and 'force' proper operation over a wide temperature range is to employ special temperature compensation techniques, such as using an Application Specific Integrated Circuit (ASIC) with memory components, or a microcontroller with software. Unfortunately, employing these 'special temperature compensation techniques' make the hall effect sensors overly complicated and require a large investment to comply with aviation standard requirements, such as DO-254 and/or DO- 178.

DE10046147C1 discloses a proximity sensor having an oscillation circuit containing an inductance (20) and a capacitance (30), with a resonance resistance dependent on the distance between the inductance and the detected object (40). An oscillator (60) coupled to the oscillation circuit has a first setting element (70) for providing a digitally variable feedback current, a second setting element (110) for temperature-dependent adjustment of a comparison threshold and a third setting element (200) for providing an analogue variable feedback current, the second and third setting elements coupled to the oscillation circuit. An Independent claim for a compensation and/or calibration method for a proximity sensor is also included.

## SUMMARY OF THE INVENTION

A proximity sensor system is provided, wherein the proximity sensor system includes a sensor article having a sensor sensing surface, wherein the sensor article is configured to sense the magnetic field of a magnetic target article located proximate the sensor sensing surface and generate a sensor signal. The proximity sensor system includes a Temperature Compensation Article (TCA), wherein the Temperature Compensation Article includes, a first Digital-to-Analog Converter (DAC), a first thermistor and a first biasing resistor, wherein the first thermistor and the first biasing resistor are connected in a parallel configuration and the first DAC is connect to the first thermistor and the first biasing resistor in a series configuration, a second DAC and a second thermistor 412, wherein the second DAC and second thermistor are connected in a series configuration, a third DAC and a Resistive Temperature Detector (RTD), wherein the third DAC and RTD are connected in a series configuration, a fourth DAC and a second biasing resistor, wherein the fourth DAC and the second biasing resistor are connected in a series configuration, wherein the outputs of the first thermistor and first biasing resistor combination, second thermistor, RTD and the second biasing resistor are connected together to generate a TCA output signal. The proximity sensor system also includes processing circuitry, wherein the processing circuitry is configured to process the sensor signal and the TCA output signal to generate a sensor system output signal.

A method for implementing a proximity sensor system is provided, wherein the proximity sensor system includes a sensor article, a Temperature Compensation Article having a plurality of Digital to Analog Converters (DACs) and processing circuitry. The method includes generating first sensor output data for a magnetic target article located at a first distance away from the sensor article, generating second sensor output data for the magnetic target article located at a second distance away from the sensor article, processing the first sensor output data and the second sensor output data to generate threshold data, configuring the Temperature Compensation Article responsive to the threshold data, calculating the digital data responsive to the threshold data, introducing the digital data into the DACs to generate a TCA output signal, generating sensor operating data, wherein the sensor operating data is generated by operating the sensor article across an operational temperature range and processing the TCA output signal and the sensor operating data to generate a sensor system output signal.

A method for generating a proximity system output signal for a proximity sensor system is provided, wherein the proximity sensor system includes a sensor article, a temperature compensation article and a processor. The method includes operating the sensor article to generate first sensor output data, wherein the first sensor output data is responsive to the sensor article sensing the magnetic field of a magnetic target article across a predefined temperature range and located at a first distance away from the sensor article, operating the sensor article to generate second sensor output data, wherein the second sensor output data is responsive to the sensor article sensing the magnetic field of a magnetic target article across the predefined temperature range and located at a second distance away from the sensor article and processing the first sensor output data and the second sensor output data to generate threshold data. The method further includes configuring the temperature compensation article to generate an output signal responsive to the threshold data, generating sensor operating data, wherein the sensor operating data is generated by operating the sensor article across an operational temperature range, wherein the operational temperature range is within the predefined temperature range and comparing the threshold data and the sensor operating data to generate at least one of a high signal and a low signal.

## BRIEF DESCRIPTION OF THE DRAWINGS

The foregoing and other features and advantages of the present invention should be more fully understood from the accompanying detailed description of illustrative embodiments taken in conjunction with the following Figures in which like elements are numbered alike in the several Figures:

FIG. 1A is a schematic block diagram showing a hall-effect based sensor, in accordance with the prior art.

FIG. 1B is a schematic block diagram showing a hall-effect based sensor system with Ferromagnetic Material as Target, in accordance with one embodiment of the invention.

FIG. 2 is a schematic block diagram showing a hall-effect based proximity sensor system, in accordance with one embodiment of the present invention.

FIG. 3 is a schematic block diagram showing a sensor article of the hall-effect based proximity sensor system of FIG. 2, in accordance with one embodiment of the present invention.

FIG. 4 is a schematic block diagram showing a sensor article of the hall-effect based proximity sensor system of FIG. 2, with the target article located closer to the sensor article than the threshold distance.

FIG. 5 is a schematic block diagram showing a sensor article of the hall-effect based proximity sensor system of FIG. 2, with the target article located farther from the sensor article than the threshold distance.

FIG. 6A illustrates the signal output of the sensor article of the hall-effect based proximity sensor system of FIG. 2 for seven (7) temperatures and two distances from the target, in accordance with one embodiment of the invention.

FIG. 6B illustrates the signal output of the sensor article of the hall-effect based proximity sensor system of FIG. 2 for seven (7) temperatures and two distances from the target along with the calculated threshold signal, in accordance with one embodiment of the invention.

FIG. 7 is a schematic block diagram of a Temperature Compensation Article (TCA) for use with the hall-effect based proximity sensor system of FIG. 2, in accordance with yet another embodiment of the invention.

FIG. 8 is a graph illustrating the output of the Temperature Compensation Article (TCA) of FIG. 7.

FIG. 9 is a schematic block diagram of the Temperature Compensation Article (TCA) of the hall-effect based proximity sensor system of FIG. 2, wherein the components of the TCA are selected to generate an output similar to the threshold output of **FIG. 6B,** in accordance with one embodiment of the invention.

**FIG. 10** is a schematic block diagram of the Temperature Compensation Article (TCA) of the hall-effect based proximity sensor system of **FIG. 2,** in accordance with another embodiment of the invention.

**FIG. 11** shows the hall-effect based proximity sensor system of **FIG. 2,** being configured as a speed sensor, in accordance with one embodiment of the invention.

**FIG. 12** shows the hall-effect based proximity sensor system of **FIG. 2,** being configured as a speed sensor, in accordance with one embodiment of the invention.

**FIG. 13** shows an operational block diagram illustrating a method for implementing the hall-effect based proximity sensor system of **FIG. 2,** in accordance with one embodiment of the invention.

**FIG. 14** shows an operational block diagram illustrating a method for generating a processed sensor signal, in accordance with one embodiment of the invention.

## DETAILED DESCRIPTION

As discussed hereinafter and in accordance with the present invention, a hall-effect based proximity sensor and a method for implementing a hall-effect based proximity sensor is provided, wherein the hall-effect based proximity sensor uses analog techniques to achieve proper operation over a wider temperature range than is currently achievable and which will not require a large investment to comply with applicable aviation standards, such as DO-254 and/or DO-178. Hall effect sensors operate on the presence or absence of a magnetic field, wherein the magnetic field is supplied by a discrete magnet and a ferromagnetic target is used as the sensing target. Referring to **FIG. 1B,** the present invention achieves hall-effect sensing by packaging a discrete magnet inside the body of the sensor, which imparts a constant magnetic bias on a chip. Then, when a ferromagnetic target comes in close proximity to the chip, the magnetic field is altered, which allows for the creation of signals that indicate the location of the target relative to the sensor (i.e. 'near' and 'far' signals).

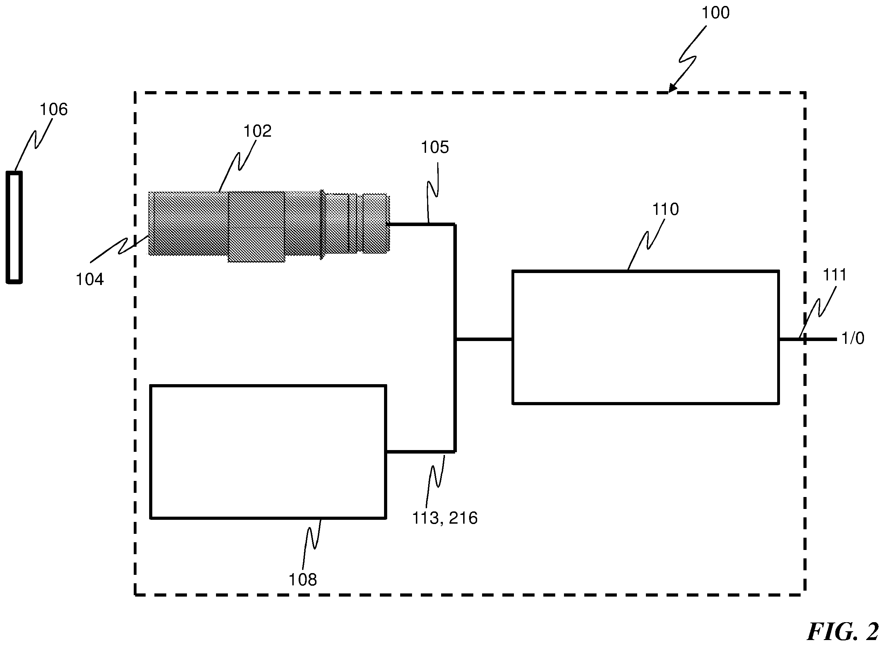

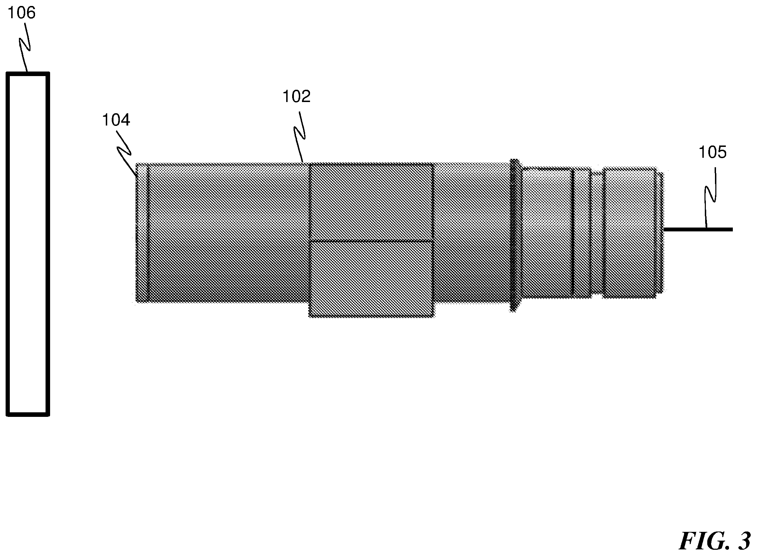

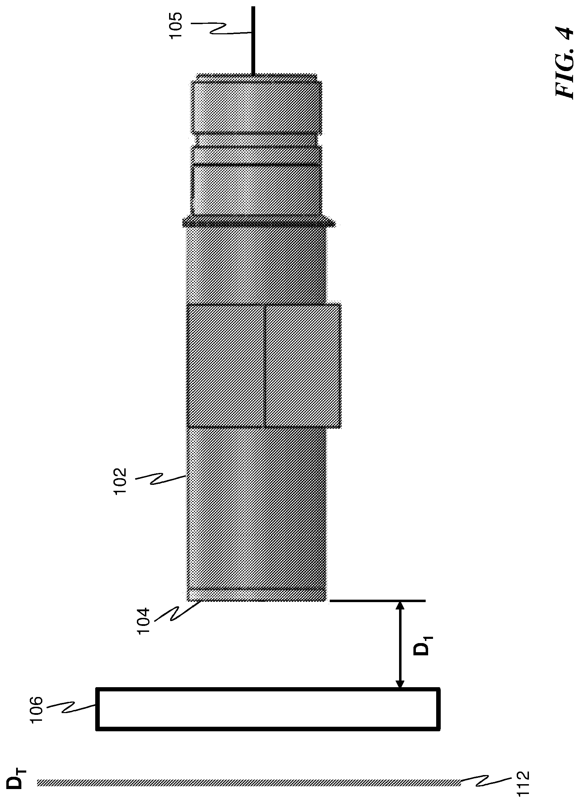

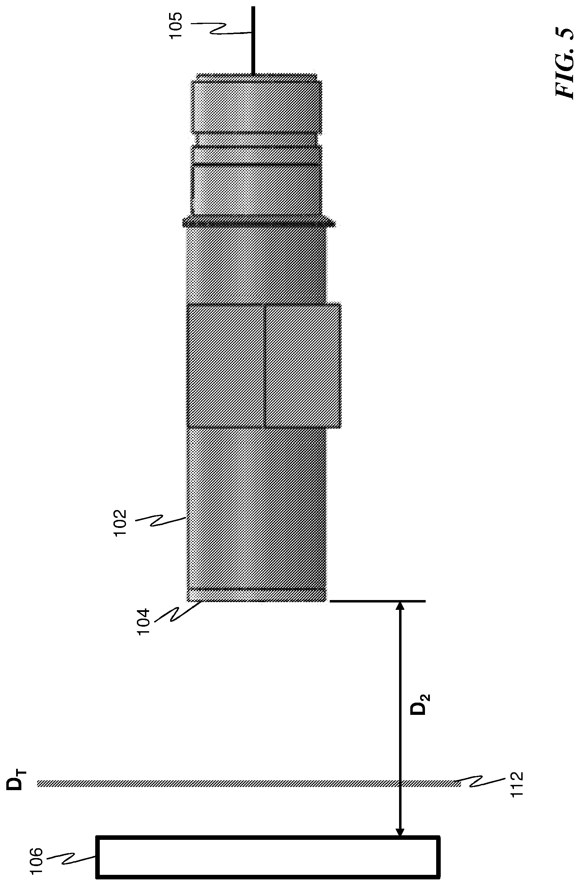

In accordance with one embodiment of the present invention, referring to **FIG. 2** and **FIG. 3,** a schematic block diagram of a hall-effect based proximity sensor system 100 is shown and includes a sensor article 102 having a sensor sensing surface (datum) 104 and a sensor output 105, a ferromagnetic (metal) target article 106, a Temperature Compensation Article (TCA) 108 and a processing module 110 having a processing module output signal 111. It should be appreciated that the hall-effect based proximity sensor system 100 is configured such that the sensor article 102 senses the proximity of the target article 106 relative to a distance away from the sensor sensing surface (datum) 104. Referring to **FIG. 4,** when the target article 106 is at a distance $D_1$ which is relatively close to the datum 104, the sensor article 102 will sense the higher magnetic field generated by the closeness of the target article 106 to the datum 104 and generate a first signal which will indicate that the target article 106 is close to the datum 104 (i.e. "TARGET NEAR" signal). Referring to **FIG. 5,** when the target article 106 is at a distance $D_2$ which is relatively far from the datum 104 (i.e. farther then distance $D_1$), the sensor article 102 will sense the lower magnetic field generated by the larger distance of the target article 106 from the datum 104 and generate a second signal which will indicate that the target article 106 is far from the datum 104 (i.e. "TARGET NEAR" signal).

It should be appreciated that although the invention is disclosed herein as having the convention that a higher (or stronger) magnetic field is associated with a closer target and a lower (or weaker) magnetic field is associated with a farther target, other embodiments may employ any convention suitable to the desired end purpose. For example, in another embodiment, the invention may be configured such that a higher (or stronger) magnetic field may be associated with a farther target and a lower (or weaker) magnetic field may be associated with a closer target. It should be appreciated that, in one embodiment, the sensor article 102 generates an analog signal proportional to the magnetic field which is directly related to the distance between the sensor sensing surface (datum) 104 and the target article 106. It should be further appreciated that the output of the sensor article 102 may be analog (i.e. continuous) indicating distance and/or the output of the sensor article 102 may be discrete to function as a proximity switch. Accordingly, it is contemplated that the sensor article may be configured to simultaneously or non-simultaneously sense distance and proximity if desired. Moreover, although the hall-effect based proximity sensor system 100 is disclosed herein as the sensor article 102 being separate from the Temperature Compensation Article (TCA) 108 and the processing module 110, it is contemplated that the sensor article 102 the Temperature Compensation Article (TCA) 108 and the processing module 110 may all be packaged within the same enclosure.

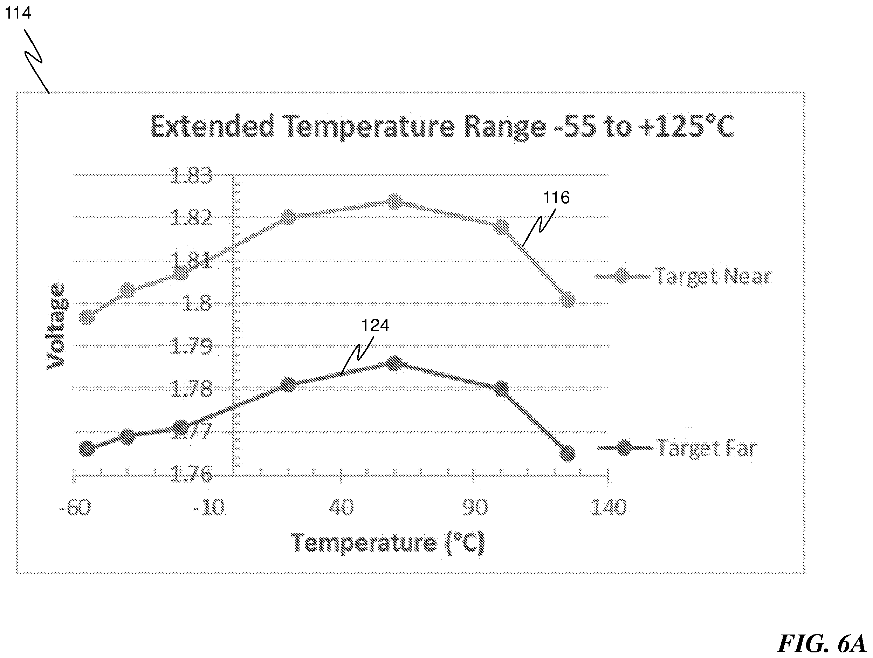

Referring to **FIG. 6A,** a graph 114 showing the output signal of one embodiment of the sensor article 102 for seven (7) different temperatures between about - 55°C and +125°C at two (2) different distances (target near, target far) is provided. It should be appreciated that, in general, in this embodiment the closer the target article 106 is to the datum 104, the higher the magnetic field sensed by the datum 104. Likewise, in general, in this embodiment the farther the target article 106 is from the datum 104, the lower the magnetic field sensed by the datum 104. As can be seen in **FIG. 6A,** the sensor article 102 is configured to generate a higher voltage with a higher magnetic field (the target article 106 is closer than the threshold distance 112) and a lower voltage with a lower magnetic field (the target article 106 is farther than the threshold distance 112). It should be appreciated that in another embodiment, the sensor article 102 may be configured to have an opposite signal polarity. As such the sensor article 102 may be configured to generate a lower voltage with a higher magnetic field (the target article 106 is closer than the threshold distance 112) and a higher voltage with a lower magnetic field (the target article 106 is farther than the threshold distance 112).

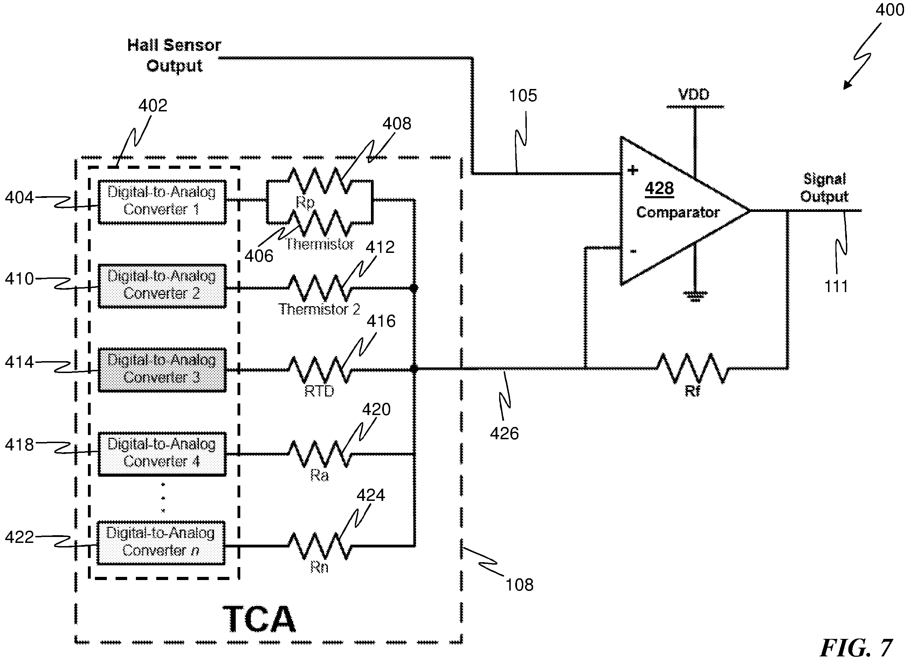

Referring to **FIG. 7,** one embodiment of the hall-effect based proximity switch system 100 is shown and uniquely provides for accuracy in generating the desired non-linear switching threshold point between the "TARGET NEAR" and "TARGET FAR" signals. The TCA 108 of the hall-effect based proximity switch system 100 includes a plurality of Digital-to-Analog Converters (DACs) 402 and includes a first DAC 404, a first thermistor 406 and a first biasing resistor 408, wherein the first thermistor 406 and the first biasing resistor 408 are connected in a parallel configuration and the first DAC 404 is connect to the first thermistor 406 and the first biasing resistor 408 in a series configuration. The hall-effect based proximity switch system 400 further includes a second DAC 410 and a second thermistor 412, wherein the second DAC 410 and second thermistor 412 are connected in a series configuration.

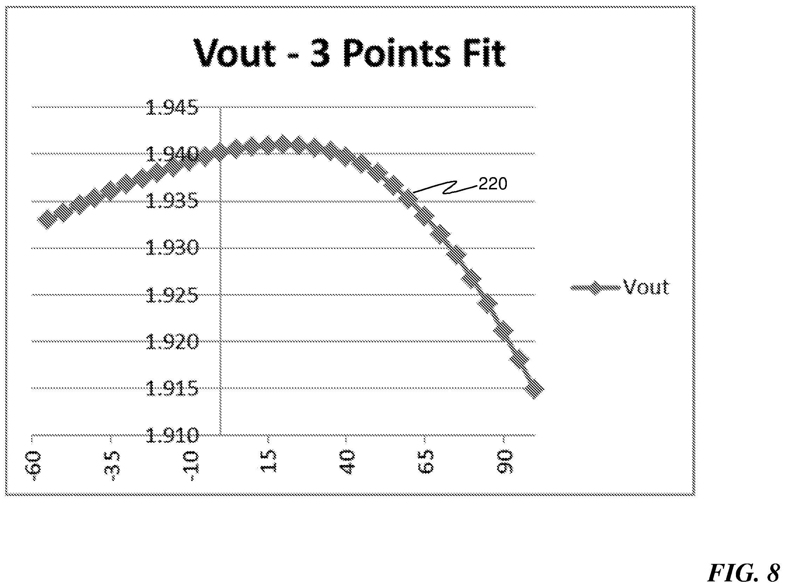

Additionally, the TCA 108 further includes a third DAC 414 and a Resistive Temperature Detector (RTD) 416, wherein the third DAC 414 and RTD 416 are connected in a series configuration. The TCA 108 also includes a fourth DAC 418 and a second biasing resistor 420, wherein the fourth DAC 418 and the second biasing resistor 420 are connected in a series configuration. The outputs of the first thermistor 406 and first biasing resistor 408 combination, second thermistor 412, RTD 416 and the second biasing resistor 420 are connected together as output $V_{Out}$ 426. It should be appreciated that any number of DACs and biasing resistors may be used as desired. For example, in **FIG. 7** a fifth DAC 422 and a third biasing resistor 424 is shown as 'DACn' and 'Rn' respectively to indicate that 'n' number of DAC's and 'n' number of biasing resistors may be used if desired. The output $V_{Out}$ 426 and the sensor output 105 is then introduced into processing circuitry, such as comparator 428 having a feedback resistor **Rf,** wherein the comparator 428 is configured to generate a digital output signal 111 which is at least one of high and low. This digital output signal 111 may then be introduced into the aircraft system as the proximity signal. Referring to **FIG. 8,** a graph illustrating the output threshold signal 220 of the TCA article 108 of **FIG. 7** at signal output 426 is shown. It should be appreciated that this threshold signal 220 is responsive to the selection of the components of the TCA article 108 and thus can be predetermined based on the selection of the components of the TCA article 108.

In this embodiment, the five (5) DACs 404, 410, 414, 418, 422 are used to generate five (5) bias points which are summed together to form output $V_{Out}$. A mathematical analysis is performed to select appropriate output values from each of the DACs 404, 410, 414, 418, 422, which in turn is dependent upon the values selected for the first thermistor 406, the second thermistor 412, the first biasing resistor 408, the second biasing resistor 420, the third biasing resistor 424 and the RTD 416. It should be further appreciated that this embodiment includes three (3) additional biasing points than TCA article 300, wherein the three (3) additional control points that are used to generate the desired non-linear threshold point and advantageously allows the ability to create the desired function in a manner which eliminates the manual resistor selection as well as results in a close to near-perfect function fit.

It should be appreciated that in one embodiment, the TCA article 300 may be configured by operating the sensor article 102 across a predefined temperature range with a magnetic target article at a first distance away from sensor (such as Target Near) to generate first sensor output data (analog). The sensor article 102 may then be operated across the predefined temperature range with the magnetic target article at a second distance away from the sensor (such as Target Far) to generate second sensor output data (analog). Threshold data may then be generated by averaging the first sensor output data and the second sensor output data. The components (i.e. resistor values, temperature dependent resistor values, etc.) of the TCA article 300 may then be selected responsive to the threshold data, wherein the values of these components may have already been optimized, i.e. the exact NTC thermistors (with correct betas), RTDs and resistor used. The digital values that are to be introduced into the EEPROM registers of the DAC's 402 to achieve the desired TCA output 426 may be calculated and the TCA output 426 may be compared with the real time sensor data 105 to generate a high or low signal output 111. Basically, once the threshold voltage has been calculated from the far and near locations, equations are solved to yield the DAC 402 settings. These DAC 402 settings are then loaded and stored in the EEPROM of each device (here using I2C). These DACs 402 may have some type of memory to hold these values for the life of the part.

It should be appreciated that the TCA article 300 may be configured via any method and/or using any components suitable to the desired end purpose. In one embodiment, the component values may be optimized to reproduce any nonlinear function. And depending on how the non-linear behavior is, some DAC and resistive components may be eliminated altogether, if desired. The mathematical solution will tell which DACs are needed or not needed. For example, equations to calculate DAC output voltages for 7 different temperatures are shown immediately hereinafter:

$$\frac{Vrv - Vthr\_n40}{Rv} + \frac{Vrtd - Vthr\_n40}{RTDn40} + \frac{Vntca - Vthr\_n40}{NTCan40} + \frac{Vntcb - Vthr\_n40}{NTCbn40} + \frac{0 - Vthr\_n40}{Rg} \approx 0$$

$$\frac{Vrv - Vthr\_n20}{Rv} + \frac{Vrtd - Vthr\_n20}{RTDn20} + \frac{Vntca - Vthr\_n20}{NTCan20} + \frac{Vntcb - Vthr\_n20}{NTCbn20} + \frac{0 - Vthr\_n20}{Rg} \approx 0$$

$$\frac{Vrv - Vthr\_0}{Rv} + \frac{Vrtd - Vthr\_0}{RTD0} + \frac{Vntca - Vthr\_0}{NTCa0} + \frac{Vntcb - Vthr\_0}{NTCb0} + \frac{0 - Vthr\_0}{Rg} \approx 0$$

$$\frac{Vrv - Vthr\_p20}{Rv} + \frac{Vrtd - Vthr\_p20}{RTDp20} + \frac{Vntca - Vthr\_p20}{NTCap20} + \frac{Vntcb - Vthr\_p20}{NTCbp20} + \frac{0 - Vthr\_p20}{Rg} \approx 0$$

$$\frac{Vrv - Vthr\_p40}{Rv} + \frac{Vrtd - Vthr\_p40}{RTDp40} + \frac{Vntca - Vthr\_p40}{NTCap40} + \frac{Vntcb - Vthr\_p40}{NTCbp40} + \frac{0 - Vthr\_p40}{Rg} \approx 0$$

$$\frac{Vrv - Vthr\_p60}{Rv} + \frac{Vrtd - Vthr\_p60}{RTDp60} + \frac{Vntca - Vthr\_p60}{NTCap60} + \frac{Vntcb - Vthr\_p60}{NTCbp60} + \frac{0 - Vthr\_p60}{Rg} \approx 0$$

$$\frac{Vrv - Vthr\_p70}{Rv} + \frac{Vrtd - Vthr\_p70}{RTDp70} + \frac{Vntca - Vthr\_p70}{NTCap70} + \frac{Vntcb - Vthr\_p70}{NTCbp70} + \frac{0 - Vthr\_p70}{Rg} \approx 0$$

$$\begin{pmatrix} xVrv \\ xVrtd \\ xVntca \\ xVntcb \end{pmatrix} := Minerr(Vrv, Vrtd, Vntca, Vntcb)$$

Vry = xVrv = 2.0261          Vntca := xVntca = 1.4054

Vrtd := xVrtd = 1.6812          Vntcb = xVntcb = 1.9274

Wherein, Vthr_x are the calculated threshold voltages, Vrv is the voltage out of DAC 418 with the fixed resistor 420, Vrtd is the voltage out of DAC 414 with RTD 416, Vntca is the voltage with the NTCa thermistor 406 and Vntcb is the voltage with the NTCb thermistor 412.

Once these voltages are known, the DAC 402 settings can be calculated (here shown as 12-bit DACs and a DAC reference voltage of 5 VDC) as shown immediately hereinafter:

$$DACrv := Round\left(\frac{Vrv}{Vref} \cdot 4096, 1\right) = 1660.0$$

$$DACrtd := Round\left(\frac{Vrtd}{Vref} \cdot 4096, 1\right) = 1377.0$$

$$DACntca := Round\left(\frac{Vntca}{Vref} \cdot 4096, 1\right) = 1151.0$$

$$DACntcb := Round\left(\frac{Vntcb}{Vref} \cdot 4096, 1\right) = 1579.0$$

,

Wherein DACrv = DAC 418, DACrtd = DAC 414, DACntca = DAC 404 and DACntcb = DAC 410.

It should be appreciated that in one embodiment, the electronic architecture of the TCA article 300 may employ 12-bit digital-to-analog (DAC) converters 402, along with a pt500 RTD 416, a 10k resistor for fixed resistor Ra 420, an NTC thermistor 412 with a β 25/50 coefficient of 3380, and an NTC thermistor 406 with a β 25/50 coefficient 4386K in parallel with a 10k resistor 408. Any suitable combination of positive and negative coefficient resistive devices, some with parallel or series fixed resistors, can be used to achieve any desired non-linear voltage output 426.

Referring again to **FIG. 4, FIG. 5, FIG. 6A** and **FIG. 7,** the graph 114 includes a first signal trace 116 that represents the output of the sensor article 102 for multiple temperatures between about -55°C and about +125°C at first distance $D_1$, when the target article 106 is relatively close to the datum 104. The graph 114 further includes a second signal trace 124 that represents the output of the sensor article 102 for multiple temperatures between about -55°C and about +125°C when the target article 106 is at second distance $D_2$, wherein the second distance $D_2$ is farther away from the datum 104 than the first distance $D_1$. It will be noticed that the same temperature data points were used to create the first signal trace 116 and the second signal trace 124.

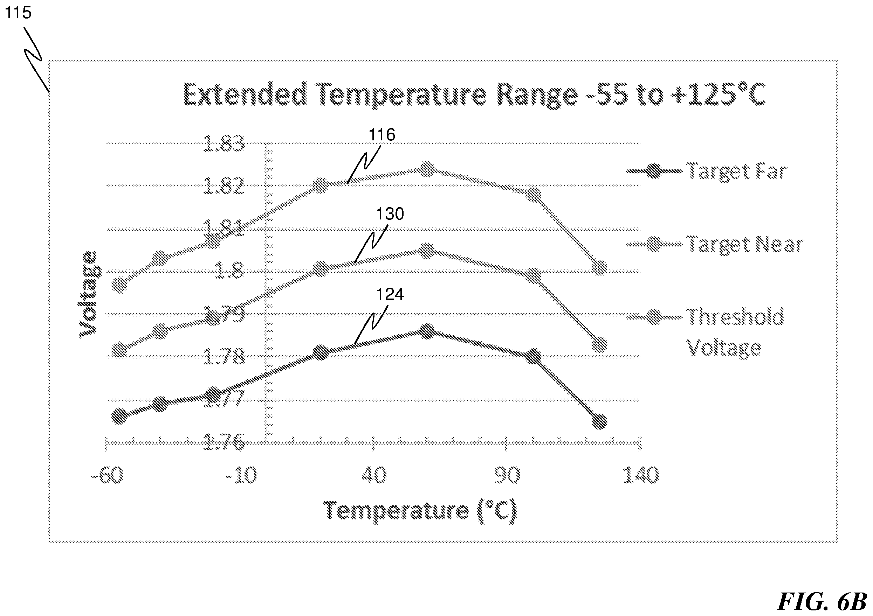

Once the first signal trace 114 and second signal trace 124 are generated, a threshold or third signal trace 130 is calculated, wherein the threshold or third signal trace 130 represents an 'average' of the first signal trace 114 and second signal trace 124. Referring to **FIG. 6B,** a graph 115 is provided and includes first signal trace 114, second signal trace 124 and third signal trace 130 which represents the threshold signal that is calculated using the data from the first signal trace 116 and the data from the second signal trace 124. It should be appreciated that although in one embodiment the third signal trace 130 is calculated by averaging the first signal trace 116 and the second signal trace 124, any method for generating third signal trace 130 may be used.

It should also be appreciated that the third signal trace 130 is representative of the target article 106 being located at a threshold distance $D_T$ away from the datum 104, wherein the threshold distance $D_T$ is located between the first distance $D_1$ and the second distance $D_2$. It should be appreciated that although only seven (7) temperatures were used to generate the first signal trace 116 and second signal trace 124 above, any number of temperatures as desired may be used. It should be appreciated that in accordance with one embodiment of the invention, the TCA 108 is then configured to generate a signal output 113 that resembles the threshold or third signal trace 130, wherein this threshold signal trace 130 represents and is very similar to the third signal trace 130 across a range of temperatures between about -55°C and about +125°C.

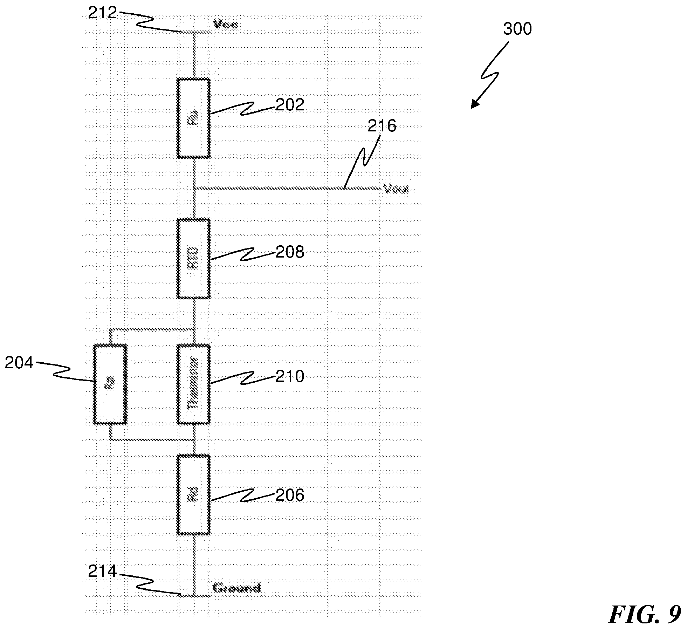

In accordance with one embodiment of the invention, the TCA 108 may be configured to generate the threshold signal trace by selecting an appropriate combination of components used in the TCA 108 that are necessary to produce the threshold signal trace 130. It should be appreciated that the selection of the combination of components may be determined using common circuit equations. Referring to **FIG. 9,** another embodiment of TCA 300 is shown and includes a first biasing resistor 202, a second biasing resistor 204, a third biasing resistor 206, a Resistive Temperature Detector (RTD) 208 and a thermistor article 210, wherein one or more of the biasing resistors 202, 204, 206 may be fixed and/or variable resistors. Additionally, it will be noted that in this embodiment the first biasing resistor 202, third biasing resistor 206, Resistive Temperature Detector (RTD) 208 and thermistor article 210 are connected in series configuration and the second biasing resistor 204 is connected in parallel with the thermistor article 210. Although in one embodiment the RTD 300 may be a component that has a linear dependence on temperature and increases its resistance with an increase in environmental temperature, it should be appreciated that any positive temperature coefficient device may be used as desired, such as, for example a PTC in conjunction with a parallel resistor. Moreover, the thermistor article 210 is preferably a component that has a non-linear dependence on temperature and decreases its resistance with an increase in environmental temperature.

It should be appreciated that appropriate selection of the values for biasing resistors 202, 204 and 206 may provide the capability to create virtually any non-linear and non-monotonic function of temperature desired regardless of whether the RTD 300 and the thermistor article 210 are connected together in parallel and/or series. Additionally, it should be appreciated that the TCA article 300 may further include a first signal input 212, a second signal input 214 and a signal output 113, 216, wherein for the TCA article 300 shown in **FIG. 9,** the first signal input 212 is shown as Vcc and the second signal input 214 is shown as ground.

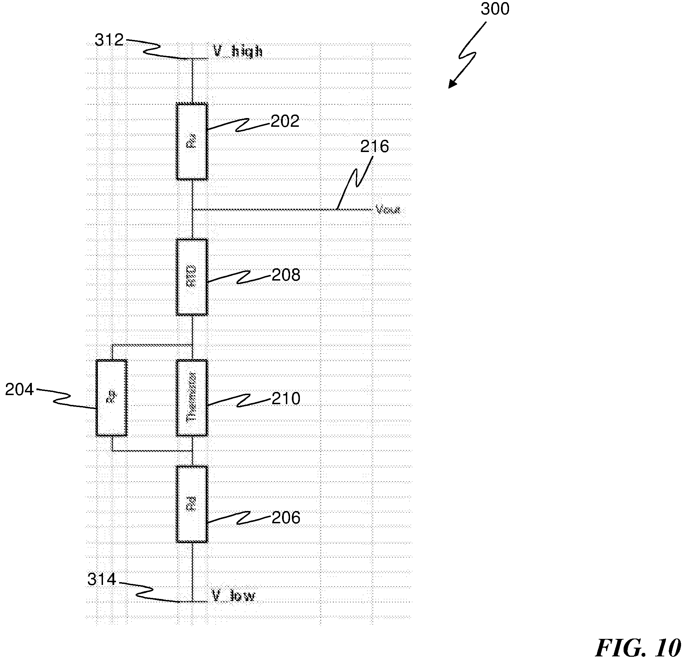

Referring to **FIG. 10,** the TCA article 300 is shown in accordance with another embodiment, wherein the first signal input 312 is shown as $V_{High}$ and the second signal input 314 is shown as $V_{Low}$. It is contemplated that $V_{High}$ and $V_{Low}$ may be set to any voltage level desired via any method suitable to the desired end purpose, such as a standard potentiometer (such as trim-pot) or by a programmable potentiometer. It should be appreciated that this method advantageously reduces the need to implement non-standard resistor values my combining multiple resistors together by programming the potentiometer(s) to the desired value(s).

It should be appreciated that in accordance with the present invention, the desired threshold signal 220 can be determined by taking measurements 1) from a sensor 102 across a temperature range of about -55°C ($\pm$15%) and about +125°C ($\pm$15%) while the target article was located at a distance near (i.e. $D_1$) to the datum 104) from a sensor across a temperature range of about -55°C ($\pm$15%) and about +125°C ($\pm$15%) while the target article was located at a distance far (i.e. $D_2$, where **D2>D1)** from the datum 104, and 3) averaging the data collect at $D_1$ and at $D_2$ for each of the temperature points. It should also be noted that the threshold signal 220 of the TCA article 108 closely resembles the third signal trace 130 (i.e. at the threshold distance 112) in **FIG. 6** and therefore represents a temperature dependent, non-linear, non-monotonic function response which matches the hall-effect Sensor output at the threshold distance 112 (i.e. third signal trace 130). Accordingly, since the threshold signal 220 of the TCA article 108 matches the third signal trace 130, this indicates that the hall-effect based proximity switch system 100 will properly operate as a proximity sensor over a wide range of temperatures ranging from about -55°C ($\pm$15%) to about +125°C ($\pm$15%). It should be appreciated that the present invention is operable over across a temperature range that exceeds about -55°C to about +125°C. In fact, the temperature operating range of the present invention is determined by the operating ranges of the components used to implement the TCA article 108 (i.e. signal conditioning electronics, power input electronics, etc.) and thus, is theoretically unlimited. For example, an operating range of about -273°C to about +650°C is possible if the components used to implement the invention are able to operate in such an environment. Furthermore, it is contemplated that in one embodiment, a high temperature magnet may be used.

It should be appreciated that in this embodiment, the five (5) DACs 404, 410, 414, 418, 422 are used to generate five (5) bias points which are summed together to form output $V_{Out}$. A mathematical analysis is performed to select appropriate output values from each of the DACs 404, 410, 414, 418, 422, which in turn is dependent upon the values selected for the first thermistor 406, the second thermistor 412, the first biasing resistor 408, the second biasing resistor 420, the third biasing resistor 424 and the RTD 416. It should be further appreciated that this embodiment includes three (3) additional biasing points than TCA article 300, wherein the three (3) additional control points that are used to generate the desired non-linear threshold point and advantageously allows the ability to create the desired function in a manner which eliminates the manual resistor selection as well as results in a close to near-perfect function fit.

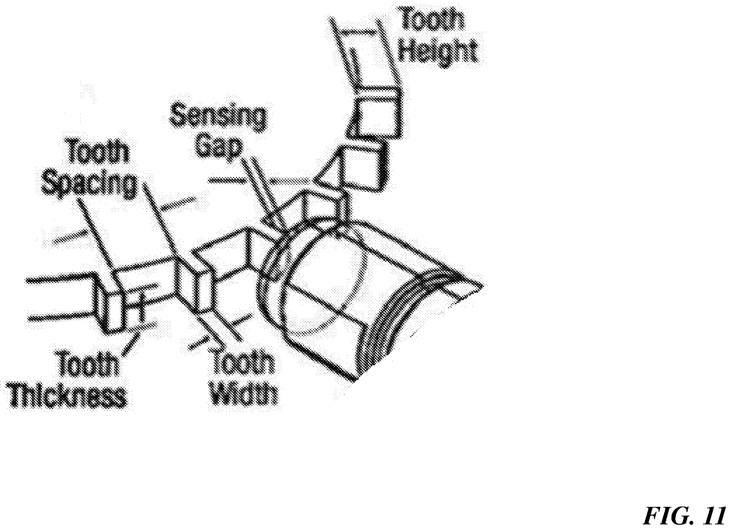

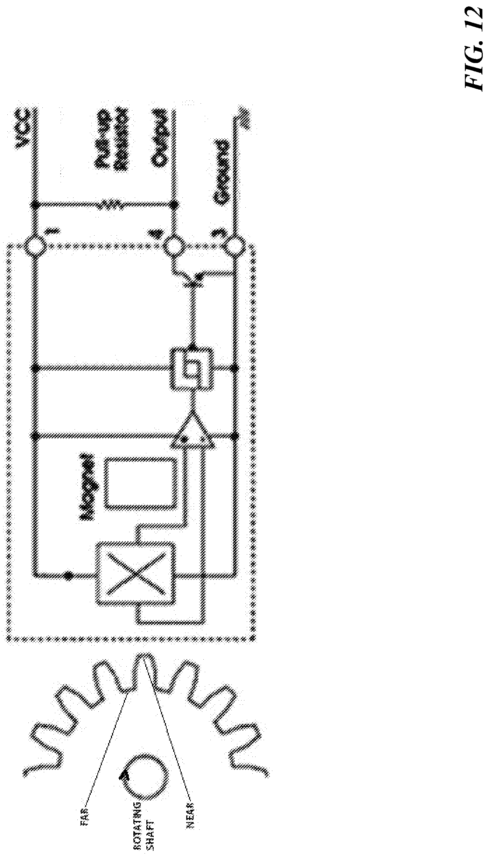

Furthermore, referring to **FIG. 11,** it is contemplated that in other embodiments, the hall-effect based proximity sensor system 100, 400 may also be configured to operate as a speed sensor, wherein the sensor article 102 can be configured to measure the rotating speed of a shaft. In this embodiment, a ferromagnetic gear may be rigidly attached to the shaft, wherein the revolution speed of the gear may (or may not) be the same as that of the shaft (i.e. geared up or down). Referring to **FIG. 11** and **FIG. 12,** the ferromagnetic gear may have a predefined number of teeth, wherein the outer diameter or width surface of each tooth may act to generate a "TARGET NEAR" signal. Additionally, each of the cavities (i.e. tooth spacing) between the gear teeth may act to generate a "TARGET FAR" signal. Thus, as the gear rotates, the hall-effect based proximity sensor system 100, 400 'detects' the "TARGET NEAR" and "TARGET FAR" conditions and generates an alternating signal which can be used to measure the rotation speed (frequency of the sensor output may be proportional to the gear revolution speed).

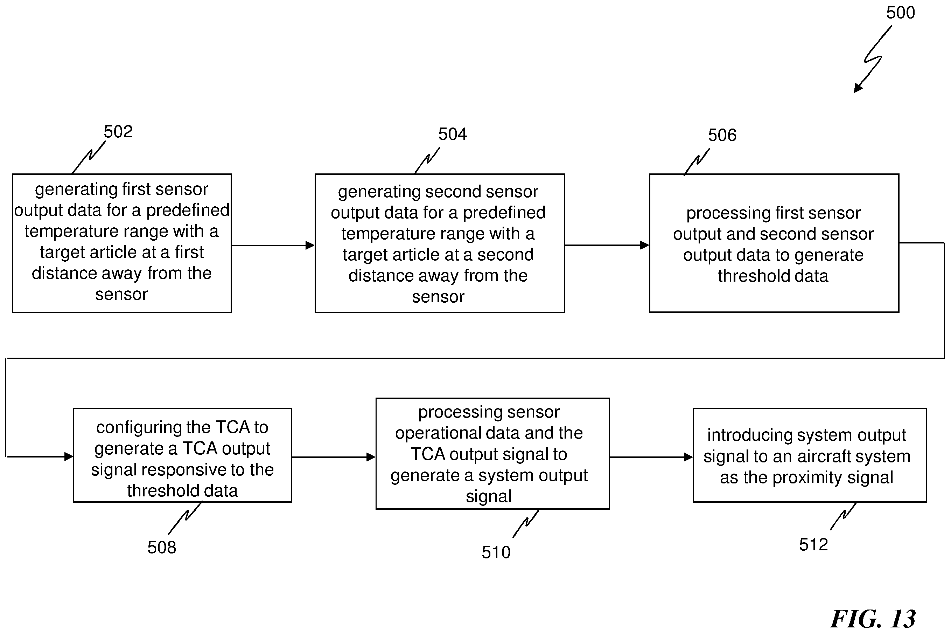

In accordance with an additional embodiment of the invention, referring to **FIG. 13, an** operational block diagram illustrating a method 500 for implementing a hall-effect based proximity switch system 100, 400, having a sensor article 102 with a datum 104, a sensor output 105, a ferromagnetic target 106, a TCA 108 and a processor 110 is provided and includes generating first sensor output data for a predefined temperature range with a target article at a first distance away from the sensor article 102, as shown in **operational block 502.** This may be accomplished by positioning the target article at a first distance away from the sensor article 102 and operating the sensor article 102 at varying temperatures across the predefined temperature range and recording the first sensor output data for one or more temperatures.

The method 500 further includes generating second sensor output data for the predefined temperature range with a target article at a second distance away from the sensor article 102, as shown in **operational block 504,** wherein the first distance is not equal to the second distance. This may be accomplished by positioning the target article at a second distance away from the sensor article 102 and operating the sensor article 102 at varying temperatures across the predefined temperature range and recording the second sensor output data for one or more temperatures. It should be appreciated that although it is contemplated that the same or similar temperature points are used to generate first sensor output data and second sensor output data, other embodiments may use different temperature points.

The method 500 includes processing the first sensor output data and the second sensor output data to generate threshold data, as shown in **operational block 506.** This may be accomplished by averaging the output data for each of the temperature points of the first and second sensor output data. The method 500 further includes configuring the TCA 108 to generate an output signal that is very similar to the threshold data across a predefined temperature range, as shown in **operational block 508.** This may be accomplished by designing the TCA 108 with the appropriate components necessary to produce TCA output data that is similar or exact to the threshold data across the predefined temperature range.

Furthermore, the method 500 includes configuring the processor 110 to process the threshold data and sensor data (as the sensor is operating in its installed environment) to generate a system output signal 111, as shown in **operational block 510,** wherein the system output signal 111 may be at least one of a high signal and a low signal. In one embodiment, this may be accomplished via comparing the sensor data with the threshold data and if the sensor data is greater than or equal to the threshold data for a particular temperature, the system output signal 111 may be high (or low), else the system output signal 111 may be low (or high). In another embodiment, this may be accomplished via comparing the sensor data with the threshold data and if the sensor data is less than or equal to the threshold data for a particular temperature, the system output signal may be high (or low), else the system output signal 111 may be low (or high). The method 500 further includes introducing the system output signal 111 to an aircraft system as the proximity signal, as shown in **operational block 512.**

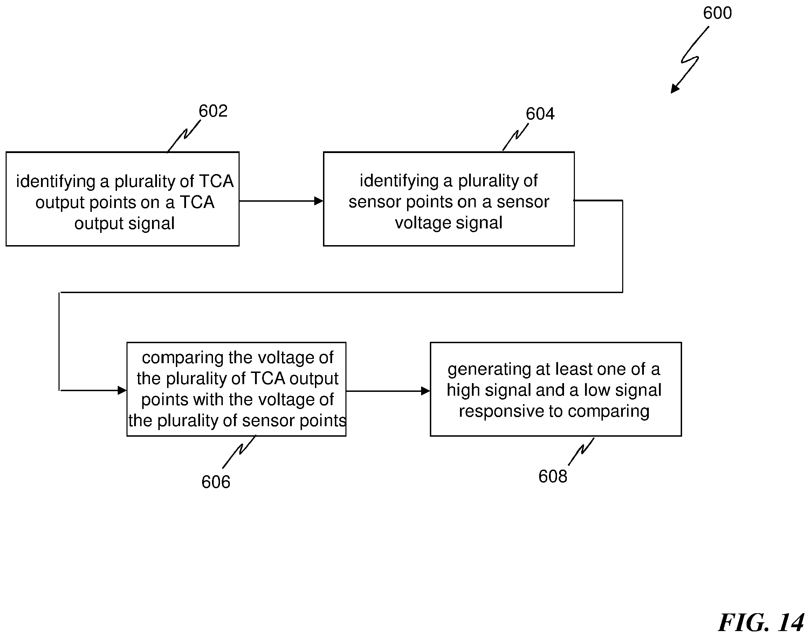

It should be appreciated that in one embodiment, the system output signal 111 may be generated via a comparator that compares the sensor signal 105 to the threshold signal 220. Referring to **FIG. 14,** an operational block diagram illustrating a method 600 for generating a proximity system output signal 111 is shown and includes identifying a plurality of threshold points on a threshold signal 220, as shown in **operational block 602,** wherein each of the plurality of threshold points corresponds to a specific temperature across a temperature range of about -55°C to about +125°C. It should be appreciated that the threshold signal 220 may be generated in response to a TCA article 108 that was designed with components that were specifically selected to cause the TCA article 108 to generate a voltage output signal across a wide temperature range having desired characteristics. For example, in one embodiment, it is desired to have a TCA output signal with defined voltage versus temperature characteristics across a temperature range of about -55°C to about +125°C. One such signal is shown in **FIG. 8,** wherein the signal was calculated as discussed herein above.

The method 600 further includes identifying a plurality of sensor points on a sensor signal, as shown in **operational block 604,** as the sensor is operating in its installed environment and wherein each of the plurality of sensor points corresponds to a specific temperature within a temperature range which is between about -55°C to about +125°C, wherein the plurality of threshold points and the plurality of sensor points correspond to the same (or similar) temperature values. The method 600 further includes comparing the voltage of the threshold points with the voltage of the sensor points at the same or similar temperature values, as shown in **operational block 606.** The method 600 further includes, for each of the temperature values, generating at least one of a high and a low signal, as shown in **operational block 608,** and as discussed herein above.

While the invention has been described with reference to an exemplary embodiment, it should be understood by those skilled in the art that various changes may be made and equivalents may be substituted for elements thereof without departing from the scope of the invention. Moreover, the embodiments or parts of the embodiments may be combined in whole or in part without departing from the scope of the invention. In addition, many modifications may be made to adapt a particular situation or material to the teachings of the invention without departing from the scope thereof. Therefore, it is intended that the invention not be limited to the particular embodiment disclosed as the best mode contemplated for carrying out this invention, but that the invention will include all embodiments falling within the scope of the appended claims. Moreover, unless specifically stated any use of the terms first, second, etc. do not denote any order or importance, but rather the terms first, second, etc. are used to distinguish one element from another.

**Claims**

1.  A proximity sensor system (100), comprising:

a sensor article (102) having a sensor sensing surface (104), wherein the sensor article (102) is configured to sense the magnetic field of a magnetic target article (106) located proximate the sensor sensing surface (104) and generate a sensor signal (105);

a Temperature Compensation Article, TCA, (108), wherein the Temperature Compensation Article (108) includes,

a first Digital-to-Analog Converter, DAC, (404), a first thermistor (406) and a first biasing resistor (408), wherein the first thermistor (406) and the first biasing resistor (408) are connected in a parallel configuration and the first DAC (404) is connect to the first thermistor (406) and the first biasing resistor (408) in a series configuration,

a second DAC (410) and a second thermistor (412), wherein the second DAC (410) and second thermistor (412) are connected in a series configuration,

a third DAC (414) and a Resistive Temperature Detector ,RTD, (416), wherein the third DAC (414) and RTD (416) are connected in a series configuration,

a fourth DAC (418) and a second biasing resistor (420), wherein the fourth DAC (418) and the second biasing resistor (420) are connected in a series configuration,

wherein the outputs of the first thermistor (406) and first biasing resistor (408) combination, second thermistor (412), RTD (416) and the second biasing resistor (420) are connected together to generate a TCA output signal (426); and

processing circuitry, wherein the processing circuitry is configured to process the sensor signal (105) and the TCA output signal (426) to generate a sensor system output signal (111).

2. The proximity sensor system (100) of claim 1, wherein the sensor signal (105) is generated responsive to the location of the magnetic target article (106) relative to the sensor sensing surface (104).

3. The proximity sensor system (100) of claim 1, wherein the sensor signal (105) is generated in response to a plurality of magnetic target article locations across an operating temperature range.

4. The proximity sensor system (100) of claim 3, wherein the operating temperature range is between about -55°C and about +125°C.

5. The proximity sensor system (100) of claim 1, wherein the predetermined TCA signal is determined by generating a first sensor signal with the target article (106) located at a first location across a predefined temperature range, generating a second sensor signal with the target article (106) located at a second location across the predefined temperature range and averaging the first and second sensor signals across the predefined temperature range.

6. The proximity sensor system (100) of claim 1, wherein the first DAC (404), first thermistor (406), first biasing resistor (408), second DAC(410), second thermistor (412), third DAC (414), Resistive Temperature Detector, RTD,(416), fourth DAC (418), second biasing resistor (420) are configured by generating a first sensor signal with the magnetic target article (106) located at a first location across a predefined temperature range, generating a second sensor signal with the magnetic target article (106) located at a second location across the predefined temperature range and averaging the first and second sensor signals across the predefined temperature range.

7. The proximity sensor system (100) of claim 6, wherein the predefined temperature range is between about -55°C and about +125°C.

8. The proximity sensor system (100) of claim 1, wherein the temperature compensation article (108) includes a first biasing resistor (408), a second biasing resistor (420), a third biasing resistor (424), a Resistive Temperature Detector, RTD (416), and a thermistor article (210), wherein the first biasing resistor (408), third biasing resistor (424)_, Resistive Temperature Detector, RTD, (416), and thermistor article (210) are connected in series configuration and the second biasing resistor (420) is connected in parallel with the thermistor article (210).

9. The proximity sensor system (100) of claim 8, wherein one or more of the first biasing resistor (408), second biasing resistor (420), and third biasing resistor (424) are at least one of a fixed resistor or a variable resistor.

10. The proximity sensor system (100) of claim 1, wherein the processing circuitry is a comparator configured to compare the sensor signal (105) with the TCA signal and generate a digital processor output signal (111).

**11.** The proximity sensor system (100) of claim 10, wherein the processor output signal (111) is at least one of a high signal and a low signal.

**12.** A method for implementing a proximity sensor system (500), wherein the proximity sensor system (100) includes a sensor article (102), a Temperature Compensation Article (108) having a plurality of Digital to Analog Converters, DACs, (402), and processing circuitry, the method comprising:

generating first sensor output data for a magnetic target article (106) located at a first distance away from the sensor article (102);

generating second sensor output data for the magnetic target article (106) located at a second distance away from the sensor article (102);

processing the first sensor output data and the second sensor output data to generate threshold data (220);

configuring the Temperature Compensation Article (108) responsive to the threshold data (220);

calculating the digital data responsive to the threshold data (220);

introducing the digital data into the plurality of DACs (402) to generate a TCA output signal (426);

generating sensor operating data, wherein the sensor operating data is generated by operating the sensor article across an operational temperature range; and

processing the TCA output signal and the sensor operating data to generate a sensor system output signal.

**13.** The method of claim 12, wherein the plurality of DACs (402) include,

a first Digital-to-Analog Converter, DAC, (404), a first thermistor (406), and a first biasing resistor (408), wherein the first thermistor (406) and the first biasing resistor (408) are connected in a parallel configuration and the first DAC (404) is connect to the first thermistor (406) and the first biasing resistor (408) in a series configuration,

a second DAC (410) and a second thermistor (412), wherein the second DAC (410) and second thermistor (412) are connected in a series configuration,

a third DAC (414) and a Resistive Temperature Detector, RTD, (416), wherein the third DAC (414) and RTD (416) are connected in a series configuration,

a fourth DAC (418) and a second biasing resistor (420), wherein the fourth DAC (418) and the second biasing resistor (420) are connected in a series configuration, wherein the outputs of the first thermistor (406) and first biasing resistor (408) combination, second thermistor (412), RTD (416), and the second biasing resistor (412) are connected together to generate the TCA output signal (426).

**14.** The method of claim 12, further including at least one of,

introducing the sensor system output signal (111) into an aircraft system,

wherein processing includes comparing the sensor operating data with TCA output signal (426) to generate at least one of a high signal and a low signal,

wherein the second distance away from the sensor article (102) is larger than the first distance away from the sensor article (102),

wherein the magnetic target article (106) includes a target magnetic portion and wherein the sensor article (102) senses the magnetic field of the target magnetic portion,

wherein generating the first sensor output data and the second sensor output data include operating the sensor article (102) across the operational temperature range, and

wherein the operational temperature range is between about -55°C and about +125°C.

**15.** The method of claim 12, wherein configuring includes selecting electrical components of the TCA (108) and connecting the electrical components together to generate a TCA output signal (426) responsive to the threshold data (220), wherein the threshold data (220) is determined by averaging the first sensor output data and the second sensor output data.

**Patentansprüche**

**1.** Näherungssensorsystem (100), umfassend:

einen Sensorartikel (102) mit einer Sensorerfassungsfläche (104), wobei der Sensorartikel (102) so konfiguriert ist, dass er das Magnetfeld eines magnetischen Zielartikels (106), der sich in der Nähe der Sensorerfassungsfläche (104) befindet, erfasst und ein Sensorsignal (105) erzeugt;

einen Temperaturkompensationsartikel (TCA), (108), wobei der Temperaturkompensationsartikel (108) Folgendes umfasst,

einen ersten Digital-zu-Analog-Wandler (DAC) (404), einen ersten Thermistor (406) und einen ersten Vorspannungswiderstand (408), wobei der erste Thermistor (406) und der erste Vorspannungswiderstand (408) in einer Parallelkonfiguration verbunden sind und der erste DAC (404) mit dem ersten Thermistor (406) und dem ersten Vorspannungswiderstand (408) in einer Reihenschaltung verbunden ist,

einen zweiten DAC (410) und einen zweiten Thermistor (412), wobei der zweite DAC (410) und der zweite Thermistor (412) in einer Reihenschaltung verbunden sind,

einen dritten DAC (414) und einen Widerstandstemperaturdetektor (RTD), (416), wobei der dritte DAC (414) und der RTD (416) in einer Reihenschaltung verbunden sind,

einen vierten DAC (418) und einen zweiten Vorspannungswiderstand (420), wobei der vierte DAC (418) und der zweite Vorspannungswiderstand (420) in einer Reihenschaltung verbunden sind,

wobei die Ausgänge der Kombination aus erstem Thermistor (406) und erstem Vorspannungswiderstand (408), zweitem Thermistor (412), RTD (416) und zweitem Vorspannungswiderstand (420) miteinander verbunden sind, um ein TCA-Ausgangssignal (426) zu erzeugen; und

eine Verarbeitungsschaltung, wobei die Verarbeitungsschaltung konfiguriert ist, um das Sensorsignal (105) und das TCA-Ausgangssignal (426) zu verarbeiten, um ein Sensorsystem-Ausgangssignal (111) zu erzeugen.

2. Näherungssensorsystem (100) nach Anspruch 1, wobei das Sensorsignal (105) als Reaktion auf die Position des magnetischen Zielgegenstands (106) relativ zur Sensorerfassungsfläche (104) erzeugt wird.

3. Näherungssensorsystem (100) nach Anspruch 1, wobei das Sensorsignal (105) als Reaktion auf eine Vielzahl von magnetischen Zielartikelpositionen über einen Betriebstemperaturbereich erzeugt wird.

4. Näherungssensorsystem (100) nach Anspruch 3, wobei der Betriebstemperaturbereich zwischen etwa -55 °C und etwa +125 °C liegt.

5. Näherungssensorsystem (100) nach Anspruch 1, wobei das vorbestimmte TCA-Signal durch Erzeugen eines ersten Sensorsignals mit dem Zielartikel (106), der sich an einem ersten Ort über einen vordefinierten Temperaturbereich befindet, bestimmt wird, wobei ein zweites Sensorsignal mit dem Zielartikel (106), der sich an einem zweiten Ort über den vordefinierten Temperaturbereich befindet, erzeugt wird, und wobei die ersten und zweiten Sensorsignale über den vordefinierten Temperaturbereich gemittelt werden.

6. Näherungssensorsystem (100) nach Anspruch 1, wobei der erste DAC (404), der erste Thermistor (406), der erste Vorspannungswiderstand (408), der zweite DAC (410), der zweite Thermistor (412), der dritte DAC (414), der Widerstandstemperaturdetektor (RTD) (416), der vierte DAC (418), der zweite Vorspannungswiderstand (420) konfiguriert werden durch Erzeugen eines ersten Sensorsignals mit dem magnetischen Zielartikel (106), der sich an einem ersten Ort über einen vordefinierten Temperaturbereich befindet, der ein zweites Sensorsignal mit dem magnetischen Zielartikel (106) erzeugt, der sich an einem zweiten Ort über den vordefinierten Temperaturbereich befindet und einen Mittelwert für die ersten und zweiten Sensorsignale über den vordefinierten Temperaturbereich bildet.

7. Näherungssensorsystem (100) nach Anspruch 6, wobei der Betriebstemperaturbereich zwischen etwa -55 °C und etwa +125 °C liegt.

8. Näherungssensorsystem (100) nach Anspruch 1, wobei der Temperaturkompensationsartikel (108) einen ersten Vorspannungswiderstand (408), einen zweiten Vorspannungswiderstand (420), einen dritten Vorspannungswiderstand (424), einen Widerstandstemperaturdetektor RTD (416) und einen Thermistorartikel (210) beinhaltet, wobei der erste Vorspannungswiderstand (408), der dritte Vorspannungswiderstand (424), der Widerstandstemperaturdetektor, RTD, (416), und der Thermistorartikel (210) in einer Reihenschaltung verbunden sind und der zweite Vorspannungswiderstand (420) parallel zu dem Thermistorartikel (210) geschaltet ist.

9. Näherungssensorsystem (100) nach Anspruch 8, wobei einer oder mehrere des ersten Vorspannungswiderstandes (408), des zweiten Vorspannungswiderstandes (420) und des dritten Vorspannungswiderstandes (424) mindestens einer von einem festen Widerstand oder einem variablen Widerstand ist.

10. Näherungssensorsystem (100) nach Anspruch 1, wobei die Verarbeitungsschaltung ein Komparator ist, der so konfiguriert ist, dass er das Sensorsignal (105) mit dem TCA-Signal vergleicht und ein digitales Prozessorausgangssignal (111) erzeugt.

11. Näherungssensorsystem (100) nach Anspruch 10, wobei das Prozessorausgangssignal (111) mindestens eines von einem hohen und einem niedrigen Signal ist.

12. Verfahren zum Implementieren eines Näherungssensorsystems (500), wobei das Näherungssensorsystem (100) einen Sensorartikel (102), einen Temperaturkompensationsartikel (108) mit einer Vielzahl von Digital-Analog-Wandlern, DACs, (402) und eine Verarbeitungsschaltung beinhaltet, wobei das Verfahren Folgendes umfasst:

Erzeugen erster Sensorausgangsdaten für einen magnetischen Zielartikel (106), der sich in einem ersten Abstand von dem Sensorartikel (102) befindet;
Erzeugen zweiter Sensorausgangsdaten für einen magnetischen Zielartikel (106), der sich in einem zweiten Abstand von dem Sensorartikel (102) befindet;
Verarbeitung der ersten Sensorausgangsdaten und der zweiten Sensorausgangsdaten zur Erzeugung von Schwellenwertdaten (220);
Konfigurieren des Temperaturkompensationsartikels (108) in Abhängigkeit von den Schwellenwertdaten (220);
Berechnung der digitalen Daten in Abhängigkeit von den Schwellwertdaten (220);
Einspeisung der digitalen Daten in die Vielzahl von DACs (402) zur Erzeugung eines TCA-Ausgangssignals (426);
Erzeugen von Sensorbetriebsdaten, wobei die Sensorbetriebsdaten durch Betreiben des Sensorartikels über einen Betriebstemperaturbereich erzeugt werden; und
Verarbeitung des TCA-Ausgangssignals und der Sensorbetriebsdaten zur Erzeugung eines Sensorsystem-Ausgangssignals.

13. Verfahren nach Anspruch 12, wobei die Vielzahl von DACs (402) Folgendes beinhaltet:

einen ersten Digital-Analog-Spannungswandler (DAC), (404), einen ersten Thermistor (406) und einen ersten Vorspannungswiderstand (408), wobei der erste Thermistor (406) und der erste Vorspannungswiderstand (408) in einer Parallelschaltung verbunden sind und der erste DAC (404) mit dem ersten Thermistor (406) und dem ersten Vorspannungswiderstand (408) in einer Reihenschaltung verbunden ist,
einen zweiten DAC (410) und einen zweiten Thermistor (412), wobei der zweite DAC (410) und der zweite Thermistor (412) in einer Reihenschaltung verbunden sind,
einen dritten DAC (414) und einen Widerstandstemperaturdetektor (RTD), (416), wobei der dritte DAC (414) und der RTD (416) in einer Reihenschaltung verbunden sind,
einen vierten DAC (418) und einen zweiten Vorspannungswiderstand (420), wobei der vierte DAC (418) und der zweite Vorspannungswiderstand (420) in einer Reihenschaltung verbunden sind, wobei die Ausgänge der Kombination aus erstem Thermistor (406) und erstem Vorspannungswiderstand (408), zweitem Thermistor (412), RTD (416) und zweitem Vorspannungswiderstand (412) miteinander verbunden sind, um das TCA-Ausgangssignal (426) zu erzeugen.

14. Verfahren nach Anspruch 12 beinhaltet ferner mindestens eines des Folgenden,

Einspeisung des Sensorsystem-Ausgangssignals (111) in ein Flugzeugsystem,
wobei die Verarbeitung den Vergleich der Sensorbetriebsdaten mit dem TCA-Ausgangssignal (426) beinhaltet, um mindestens ein Hochsignal oder ein Tiefsignal zu erzeugen,
wobei der zweite Abstand von dem Sensorartikel (102) größer ist als der erste Abstand von dem Sensorartikel (102),
wobei der magnetische Zielartikel (106) einen magnetischen Zielabschnitt beinhaltet und wobei der Sensorartikel (102) das Magnetfeld des magnetischen Zielabschnitts erfasst,
wobei das Erzeugen der ersten Sensorausgangsdaten und der zweiten Sensorausgangsdaten das Betreiben des Sensorartikels (102) über den Betriebstemperaturbereich beinhaltet, und
wobei der Betriebstemperaturbereich zwischen etwa -55 °C und etwa +125 °C liegt.

15. Verfahren nach Anspruch 12, wobei das Konfigurieren das Auswählen elektrischer Komponenten des TCA (108) und das Verbinden der elektrischen Komponenten miteinander beinhaltet, um ein TCA-Ausgangssignal (426) zu erzeugen, das auf die Schwellenwertdaten (220) reagiert, wobei die Schwellenwertdaten (220) durch Mittelwertbildung der ersten Sensorausgangsdaten und der zweiten Sensorausgangsdaten bestimmt werden.

**Revendications**

1.  Système de capteur de proximité (100), comprenant :

    un article capteur (102) présentant une surface de détection de capteur (104), dans lequel l'article capteur (102) est configuré pour détecter le champ magnétique d'un article cible magnétique (106) situé à proximité de la surface de détection de capteur (104) et générer un signal de capteur (105) ;
    un article de compensation de température, TCA, (108), dans lequel l'article de compensation de température (108) comporte, un premier convertisseur numérique-analogique, CNA, (404), une première thermistance (406) et une première résistance de polarisation (408), dans lequel la première thermistance (406) et la première résistance de polarisation (408) sont reliées en parallèle, et le premier CNA (404) est relié en série à la première thermistance (406) et à la première résistance de polarisation (408),
    un deuxième CNA (410) et une seconde thermistance (412), dans lequel le deuxième CNA (410) et la seconde thermistance (412) sont reliés en série,
    un troisième CNA (414) et un détecteur de température résistif, RTD, (416), dans lequel le troisième CNA (414) et le RTD (416) sont reliés en série,
    un quatrième CNA (418) et une deuxième résistance de polarisation (420), dans lequel le quatrième CNA (418) et la deuxième résistance de polarisation (420) étant reliés en série, dans lequel les sorties de la première thermistance (406) et de la première résistance de polarisation (408), de la seconde thermistance (412), du RTD (416) et de la deuxième résistance de polarisation (420) sont reliées ensemble pour générer un signal de sortie de TCA (426) ; et
    un ensemble de circuits de traitement, dans lequel l'ensemble de circuits de traitement est configuré pour traiter le signal de capteur (105) et le signal de sortie de TCA (426) pour générer un signal de sortie de système de capteur (111).

2.  Système de capteur de proximité (100) selon la revendication 1, dans lequel le signal de capteur (105) est généré en réponse à l'emplacement de l'article cible magnétique (106) par rapport à la surface de détection de capteur (104).

3.  Système de capteur de proximité (100) selon la revendication 1, dans lequel le signal de capteur (105) est généré en réponse à une pluralité d'emplacements d'articles cibles magnétiques sur une plage de température de fonctionnement.

4.  Système de capteur de proximité (100) selon la revendication 3, dans lequel la plage de température de fonctionnement est comprise entre environ -55 °C et environ +125 °C.

5.  Système de capteur de proximité (100) selon la revendication 1, dans lequel le signal de TCA prédéterminé est déterminé en générant un premier signal de capteur avec l'article cible (106) situé à un premier emplacement sur une plage de température prédéfinie, en générant un second signal de capteur avec l'article cible (106) situé à un second emplacement sur la plage de température prédéfinie et en faisant la moyenne des premier et second signaux de capteur sur la plage de température prédéfinie.

6.  Système de capteur de proximité (100) selon la revendication 1, dans lequel le premier CNA (404), la première thermistance (406), la première résistance de polarisation (408), le deuxième CNA (410), la seconde thermistance (412), le troisième CNA (414), le détecteur de température résistif, RTD (416), le quatrième CNA (418), la deuxième résistance de polarisation (420) sont configurés en générant un premier signal de capteur avec l'article cible magnétique (106) situé à un premier emplacement sur une plage de température prédéfinie, en générant un second signal de capteur avec l'article cible magnétique (106) situé à un second emplacement sur la plage de température prédéfinie et en faisant la moyenne des premier et second signaux de capteur sur la plage de température prédéfinie.

7.  Système de capteur de proximité (100) selon la revendication 6, dans lequel la plage de température prédéfinie est comprise entre environ -55 °C et environ +125 °C.

8.  Système de capteur de proximité (100) selon la revendication 1, dans lequel l'article de compensation de température (108) comporte une première résistance de polarisation (408), une deuxième résistance de polarisation (420), une troisième résistance de polarisation (424), un détecteur de température résistif, RTD (416), et un article de thermistance (210), dans lequel la première résistance de polarisation (408), la troisième résistance de polarisation (424), le détecteur de température résistif, RTD (416), et l'article de thermistance (210) sont reliés en série et la deuxième résistance de polarisation (420) est reliée en parallèle à l'article de thermistance (210).

9. Système de capteur de proximité (100) selon la revendication 8, dans lequel une ou plusieurs parmi la première résistance de polarisation (408), la seconde résistance de polarisation (420) et la troisième résistance de polarisation (424) sont au moins l'une parmi une résistance fixe ou une résistance variable.

10. Système de capteur de proximité (100) selon la revendication 1, dans lequel l'ensemble de circuits de traitement est un comparateur configuré pour comparer le signal de capteur (105) au signal de TCA et générer un signal de sortie de processeur numérique (111).

11. Système de capteur de proximité (100) selon la revendication 10, dans lequel le signal de sortie de processeur (111) est au moins l'un parmi un signal haut et un signal bas.

12. Procédé de mise en œuvre d'un système de capteur de proximité (500), dans lequel le système de capteur de proximité (100) comporte un article de capteur (102), un article de compensation de température (108) présentant une pluralité de convertisseurs numériques-analogiques (CNA) (402) et un ensemble de circuits de traitement, le procédé comprenant :

la génération de premières données de sortie de capteur pour un article cible magnétique (106) situé à une première distance de l'article capteur (102) ;
la génération de secondes données de sortie de capteur pour l'article cible magnétique (106) situé à une seconde distance de l'article capteur (102) ;
le traitement des premières données de sortie de capteur et des secondes données de sortie de capteur pour générer des données de seuil (220) ;
la configuration de l'article de compensation de température (108) en réponse aux données de seuil (220) ;
le calcul des données numériques en réponse aux données de seuil (220) ;
l'introduction des données numériques dans la pluralité de CNA (402) pour générer un signal de sortie de TCA (426) ;
la génération de données de fonctionnement de capteur, dans lequel les données de fonctionnement de capteur sont générées en faisant fonctionner l'article capteur sur une plage de température de fonctionnement ; et
le traitement du signal de sortie de TCA et des données de fonctionnement de capteur pour générer un signal de sortie de système de capteur.

13. Procédé selon la revendication 12, dans lequel la pluralité de CNA (402) comportent,

un premier convertisseur numérique-analogique, CNA, (404), une première thermistance (406) et une première résistance de polarisation (408), dans lequel la première thermistance (406), et la première résistance de polarisation (408) sont reliées en parallèle, et le premier CNA (404) est relié en série à la première thermistance (406) et à la première résistance de polarisation (408),
un deuxième CNA (410) et une seconde thermistance (412), dans lequel le deuxième CNA (410) et la seconde thermistance (412) sont reliés en série,
un troisième CNA (414) et un détecteur de température résistif, RTD, (416), dans lequel le troisième CNA (414) et le RTD (416) sont reliés en série,
un quatrième CNA (418) et une deuxième résistance de polarisation (420), dans lequel le quatrième CNA (418) et la deuxième résistance de polarisation (420) sont reliés en série, dans lequel les sorties de la combinaison de la première de thermistance (406) et de la première résistance de polarisation (408), de la seconde thermistance (412), du RTD (416), et de la deuxième résistance de polarisation (412) sont reliées ensemble pour générer le signal de sortie de TCA (426).

14. Procédé selon la revendication 12, comportant en outre au moins l'une parmi,

l'introduction du signal de sortie de système de capteur (111) dans un système d'aéronef,
dans lequel le traitement comporte la comparaison des données de fonctionnement de capteur avec le signal de sortie de TCA (426) pour générer au moins l'un parmi un signal haut et d'un signal bas,
dans lequel la seconde distance par rapport à l'article capteur (102) est plus grande que la première distance par rapport à l'article capteur (102),
dans lequel l'article cible magnétique (106) comporte une partie magnétique cible et dans lequel l'article capteur (102) détecte le champ magnétique de la partie magnétique cible,
dans lequel la génération des premières données de sortie de capteur et des secondes données de sortie de capteur comporte le fonctionnement de l'article capteur (102) sur toute la plage de température de fonctionnement, et

dans lequel la plage de température de fonctionnement est comprise entre environ -55°C et environ +125°C.

15. Procédé selon la revendication 12, dans lequel la configuration comporte la sélection de composants électriques du TCA (108) et la connexion des composants électriques ensemble pour générer un signal de sortie de TCA (426) sensible aux données de seuil (220), dans lequel les données de seuil (220) sont déterminées en faisant la moyenne des premières données de sortie de capteur et des secondes données de sortie de capteur.

**Magnet**
**samarium cobalt**
Dynamic (moves)

Static (does not move)
**Hall Effect**
Sensor

S N

3.2 mm

Measured
Distance

*Prior Art*                    *FIG. 1A*

*FIG. 1B*

*FIG. 2*

*FIG. 3*

*FIG. 4*

*FIG. 5*

FIG. 6A

EP 3 963 290 B1

FIG. 6B

**FIG. 7**

EP 3 963 290 B1

**Vout - 3 Points Fit**

FIG. 8

**FIG. 9**

EP 3 963 290 B1

*FIG. 10*

*FIG. 11*

EP 3 963 290 B1

FAR

ROTATING
SHAFT

NEAR

Magnet

VCC

Pull-up
Resistor

Output

Ground

*FIG. 12*

EP 3 963 290 B1

500

| 502 | 504 | 506 |
|---|---|---|
| generating first sensor output data for a predefined temperature range with a target article at a first distance away from the sensor | generating second sensor output data for a predefined temperature range with a target article at a second distance away from the sensor | processing first sensor output and second sensor output data to generate threshold data |

| configuring the TCA to generate a TCA output signal responsive to the threshold data | processing sensor operational data and the TCA output signal to generate a system output signal | introducing system output signal to an aircraft system as the proximity signal |
|---|---|---|
| 508 | 510 | 512 |

*FIG. 13*

EP 3 963 290 B1

600

602

identifying a plurality of TCA output points on a TCA output signal

604

identifying a plurality of sensor points on a sensor voltage signal

comparing the voltage of the plurality of TCA output points with the voltage of the plurality of sensor points

generating at least one of a high signal and a low signal responsive to comparing

606

608

*FIG. 14*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 10046147 C1